# EUROPEAN PATENT APPLICATION

(11) **EP 2 660 204 A1**
(43) Date of publication of application: **06.11.2013**
(21) Application number: 12732208.9
(22) Date of filing: 05.01.2012
(51) Int. Cl.: C01G 9/02, H01B 5/14, H01B 13/00

(54) **METHOD FOR PRODUCING CONDUCTIVE ZINC OXIDE FILM**

(30) Priority: 07.01.2011 JP 2011002026
(71) Applicant: Tokyo Institute of Technology, Tokyo 152-8550 (JP); National Institute for Materials Science, Tsukuba-shi, Ibaraki 305-0047 (JP)
(72) Inventor: MATSUSHITA, Nobuhiro, Yokohama-shi Kanagawa 226-8503 (JP); WAGATA, Hajime, Yokohama-shi Kanagawa 226-8503 (JP); OHASHI, Naoki, Tsukuba-shi Ibaraki 305-0047 (JP); OKADA, Kiyoshi, Yokohama-shi Kanagawa 226-8503 (JP)
(74) Representative: Manitz, Finsterwald & Partner GbR
(86) International application number: PCT/JP2012/000029
(87) International publication number: WO 2012/093658

(57) **Abstract**

[Objective] To provide a novel preparation method for a conductive ZnO film which realizes large area and mass productions with low costs and low environment loads.

[Means for Addressing Object]

The crystal of zinc oxide (ZnO) is deposited on a substrate by a precipitation method using liquidous solution method under the presence of citric acid. The citric acid adsorbs on the surface of (0001) face of ZnO to suppress anisotropic growth to a c axis direction of the crystal in the precipitation reaction and to form dense crystal film on the surface of the substrate. Then, the organic acid incorporated in the film is photo-decomposed by irradiating UV light to the prepared ZnO crystalline film. As the result, carriers trapped by the organic acid is released to the crystalline film so as to provide an adequate conductivity.

## Description

### TECHNICAL FIELD

The present invention relate to a method for preparing a conductive zinc oxide film and more particularly relates to a method for preparing a conductive zinc oxide film by a precipitation method using liquidous solutions..

Recently, as a material for a transparent electrode, usage of zinc oxide (ZnO) with lower material costs instead of tin doped indium oxide (ITO) which contains a rare element has been studied. ZnO is a typical compound with uncertain ratio and exhibits n-type conductivity by oxygen loss or inter-lattice zinc. It is known that by using group IV elements such as Al and Ga etc. as dopants the conductivity thereof may be enhanced. The conductive ZnO film with resistivity of 10⁻⁴ ohmxcm has been so far prepared by using sputtering methods and ion plating methods. Japanese Patent (Laid-Open) JP2000-273617 (Patent Literature 1) discloses the method for preparing a transparent conductive film of ZnO by the sputtering method and/or ion plating method. However, the film formation by vapor phase methods such as sputtering causes the problems that the production cost becomes excessively high due to its high energy process which requires a large scale vacuum apparatus and the method may not suitable for large area precipitation and mass production.

With this regard, studies for film formation of ZnO film from precursor solution using a wet process such as sol-gel methods; however, the wet process must require heat treatments for crystallization so that the energy cost problem must still be remained and another problem that the process may not be applied to a plastic substrate having low glass transition temperature.

### PRIOR ART LITERATURE

### PATENT LITERATURE

Patent Literature 1: Japanese Patent (Laid-Open) JP2000-273617

### SUMMARY OF INVENTION

### OBJECT TO BE SOLVED BY INVENTION

The present invention has been made by considering the above conventional technology and the object of the present invention is to provide a novel preparation method of the ZnO film which realizes large area and mass production with low costs and low environment loads.

### MEANS FOR ADDRESSING PROBLEM

The inventors have been contemplated to constructions for realizing large area and mass productions with low costs and low environment loads in the preparation method of conductive ZnO film and have obtained the idea that a precipitation method using liquidous solution, which easily realizes large area and mass productions without requiring vacuum facilities and heat treatment processes, can be applied to the film forming of the ZnO film. In the course of experimental trials, the inventors encountered to the problem that the ZnO crystals grew like as a needle point holder so that dense crystal film may not be formed on the substrate. With respect to this point, the inventors have found that the film shape may be preferably controlled by addition of an organic acid to the precipitation reaction system. Furthermore, the inventors have found that a lot of carriers may be generated in the ZnO film by removing the organic acid incorporated into the crystal film during the growth process by using the photo-catalyst function of ZnO to complete the present invention.

Thus according to the present invention, a method for preparing a conductive zinc oxide film, which comprises the step of depositing a zinc oxide film on a substrate by a precipitation method using a liquidous under the presence of organic acid; and removing the organic acid from the zinc oxide film by irradiating UV light to the substrate, may be provided. According to the present invention, the organic acid may be carboxylic acid. According to the present invention, the carboxylic acid may be selected from the group consisting of citric acid, maleic acid, dimethyl-mercapto-succinic acid, phenol phtalein, and eosin-Y. According to the present invention, the precipitation step may be conducted using a spin spray method. According to the present invention, the substrate may be made of a material having low glass transition temperature. According to the present invention, the material having the low glass transition temperature may be inorganic glass. According to the present invention, the material having the low glass transition temperature may be a plastic material.

### TECHNICAL ADVANTAGE OF INVENTION

As described above, according to the present invention, a novel preparation method of the ZnO film which realizes large area and mass productions with low costs and low environment loads may be provided. According to the present invention, conductive ZnO films with large area may be produced in large amounts independent from substrate materials by the process of energy saving and low environment loading with using simple apparatuses.

### BRIEF DESCRIPTION OF DRAWINGS

[Fig. 1] A flow chart illustrating a preparation process of a conductive zinc oxide of the present invention.
[Fig. 2] A drawing illustrating a spin spray apparatus used in the present example.
[Fig. 3] An electron microscope of the zinc oxide film of the present example.
[Fig. 4] A drawing showing result of XRD measurement of zinc oxide film of the present example.
[Fig. 5] A drawing showing the relation between the UV irradiation time durations (min) and the resistivity (ohm cm) for each of three kinds of the zinc oxide film.
[Fig. 6] A drawing for obtaining band gaps from light transmittances about the zinc oxide of the present example.

### EMBODIMENT FOR PRACTICING INVENTION

Herein below, the present invention will be described using practical embodiments depicted in drawings; however, the present invention must not be limited to the practical embodiments depicted in the drawings.

In the preparation method for conductive zinc oxide film of the present invention, the film forming process thereof may be conducted using the liquid phase precipitation method (LPD: Liquid Phase Deposition). The LPD method may be referred to the method for depositing the crystal of metal oxide from aqueous solution. By the LPD method, the uniform crystalline thin film of the metal oxides may be formed on a surface of the substrate by causing synthesis reaction of the metal oxides in the aqueous solution and then depositing the crystals of the metal oxides directly on the substrate. According to the LPD method, the crystalline thin film of the metal oxide may be formed in relatively lower temperature condition not more than 100 Celsius degrees such that the heat treatment process for the crystallization must be omitted.

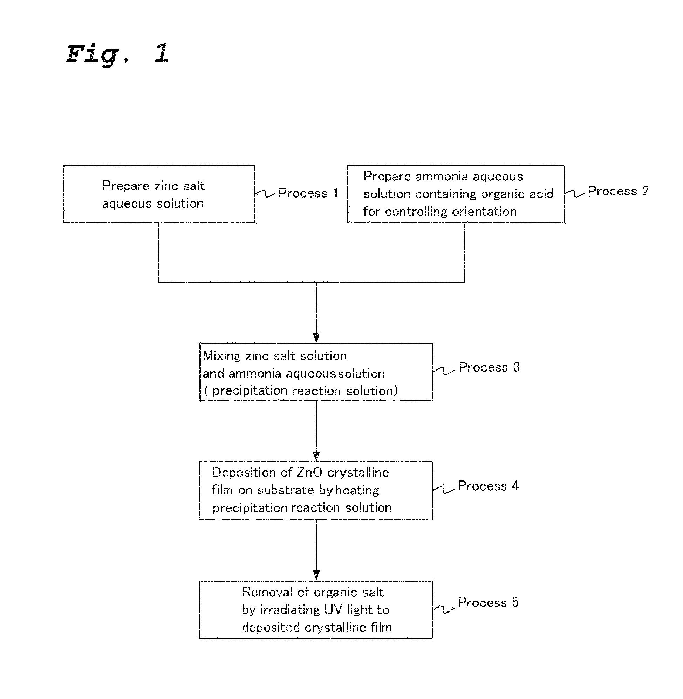

Hereafter, the present preparation method for the conductive zinc oxide film will be explained according to the flowchart shown in Fig. 1.

### (Process 1)

A zinc salt aqueous solution (zinc ion aqueous solution) is prepared by dissolving zinc salt in pure water. The zinc salts in the present invention may include such as, for example, zinc nitrate [Zn(NO₃)₂], zinc sulfate [ZnSO₄], and zinc chloride [ZnCl₂]. For example, when zinc nitrate [Zn(NO)₃] is used as the zinc salt, zinc may be ionized as the divalent ion as shown in Fig. 1 in the aqueous zinc nitrate solution:

[Chemical 1]

**Zn(NO₃)₂ + aq → Zn²⁺ + 2NO₃⁻** (1)

### (Process 2)

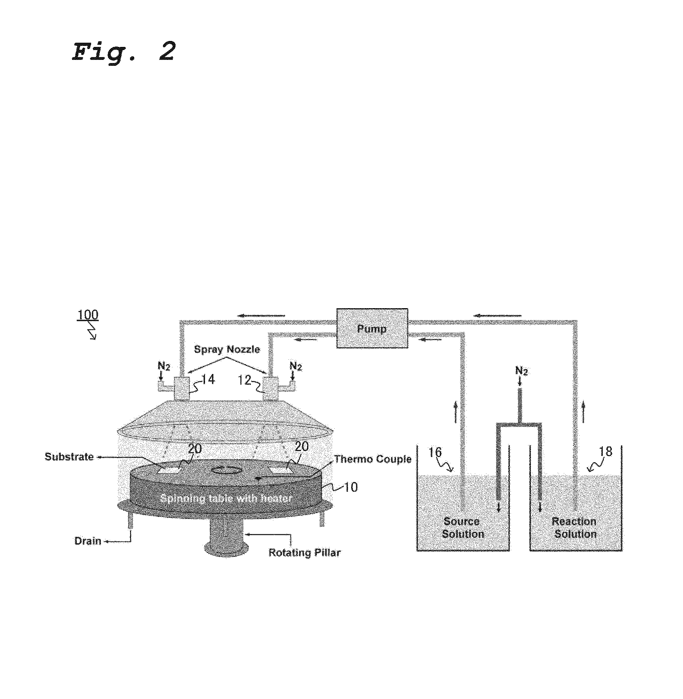

An aqueous solution of ammonia (ammonium hydroxide aqueous solution) is prepared. The ammonia aqueous solution becomes to the equilibrium state shown in Fig. 2:

[Chemical 2]

**NH₃ + H₂O ⇔ NH⁴⁺ + OH⁻** (2)

Now, the present invention is characterized in that the substance for controlling the orientation of ZnO crystals is added to the precipitation reaction system. Here, this aspect will be explained.

Usually, a growth rate at (0001) face of ZnO crystal in an aqueous solution is the highest one and then in this condition the needle like crystals showing anisotropic growth to the c axis direction are randomly jumbled up on the substrate to form the needle point holder and the dense film structure may not be obtained. For addressing to the above phenomenon, the inventors assumed that dense crystalline film should be obtained by adding the substance which adsorbs to the surface of ZnO (0001) to the precipitation reaction system so as to suppress the anisotropic growth along with the c axis. Depending on the above idea, as the result of earnest studies of the present inventors, it was found that the organic acid having a carboxylic group might be useful for the additive for controlling the orientation of the ZnO crystal.

In the present invention, such organic acid may include, for example, citric acid and other acid such as maleic acid or dimelcaptosuccinic acid as the dicarboxylic acid and phenol phtalein or eosin-Y as the monocarboxylic acid. The organic acids may be added by dissolving the organic acid salt into the zinc salt aqueous solution or the ammonia aqueous solution. The flow chart of Fig. 1 illustrates the embodiment that the organic acid is added to the ammonia aqueous solution.

### (Process 3)

The zinc salt aqueous solution prepared in the process 1 and the ammonia aqueous water containing the organic acid prepared in the process 2 are mixed to product the precipitation reaction solution. The precipitation reaction solution becomes to the supersaturation condition of Zn(NH₃)₄²⁺shown in the following formula (3):

[Chemical 3]

**Zn²⁺ + 4NH₃ ⇔ Zn(NH₃)₄²⁺** (3)

### (Process 4)

Next, the above described precipitation reaction solution is heated in the condition that the solution contacts to the substrate to an adequate film formation temperature (50 Celsius degrees-100 Celsius degrees). Then, the supersaturation condition of the precipitation reaction system changes by the heating and ZnO directly deposits onto the surface of the substrate as shown in the formula (4):

[Chemical 4]

**Zn(NH₃)₄²⁺ + 2OH⁻ → ZnO ↓ + 4NH₃ + H₂O** (4)

According to the present invention, the crystallization reaction shown in the formula (4) proceeds under the presence of the organic acid and then the anisotropic growth along to the c axis of the ZnO crystal may be controlled, thereby the densely continuous crystal film of ZnO is formed on the surface of the substrate. In one of the conventional method, the process for crystallizing ZnO by the heat treatment is included such that there was no way but using the heat resistant materials such as silica glass as the substrate having high glass transition temperature; however, it may be desired to use the inorganic glass material such as soda lime glass having relatively low glass transition temperature. In this regard, The present method using the LPD method may exclude the heat treatment process such that inorganic glass materials and plastic materials having low glass transition temperature may be used as the substrate as well as the heat resistant glass or silicon.

Here, the process 3 and the process 4 may be performed by using a spin spray method. Particularly, the substrate is placed on a turn table equipped with a heater and then the substrate is heated to keep an adequate film forming temperature while turning the turn table. Further then the above described zinc salt aqueous solution and the ammonia aqueous solution containing the organic acid are sprayed from separate nozzles onto the heated substrate to deposit the ZnO crystal directly on the substrate. Furthermore, the method for practicing the process 3 and the process 4 may not be limited to the spin spray method and any method may be used so far as the method may facilitate the substrate heating mechanism, the mechanism for mixing both solutions on the heated substrate and a removal mechanism for removing unnecessary products and wasted and supplied solutions which becomes unnecessary without contribution to the reaction. Furthermore, according to the present invention, the precipitation reaction solution may be prepared beforehand by mixing the zinc salt aqueous solution, the ammonia aqueous solution and the organic acid and then the substrate may be immersed in the precipitation reaction solution and further then the reaction system is heated to deposit ZnO on the substrate.

### (Process 5)

In the process 4, when the ZnO crystalline film is formed on the substrate, the organic acid is incorporated in the film. As the result, defects coming from the organic acid are generated in the crystalline film and the defects may make carriers. However, the generated carriers are trapped by the organic acid as generated such that the ZnO film just after the process 3 is finished does not exhibit substantial conductivity. Therefore, the organic acid incorporated in the crystalline film is removed in the process 5 using the photo-catalytic activity. The organic acid in the film may be photo decomposed by irradiating UV light to the ZnO crystalline film. As the result, the carriers trapped by the organic acid may be released to the crystalline film to provide adequate conductivity to the ZnO crystalline film.

Here, the UV light to be used may be preferably selected from adequate wavelength light considering transmittance etc. so as to decompose every organic acid by reaching all over inside the crystalline film. In zinc oxide, it is known that the optical band gap is broadened as increase of carrier concentration according to the phenomenon so-called as Bernstein-Moss shift. Therefore, the UV light to be irradiated may preferably include shorter wavelength side light corresponding to the broadened optical band gap as well as the wavelength corresponding to the original band gap of zinc oxide.

As described so far, according to the present invention, the conductive ZnO crystalline film with a large area without selecting the substrate materials may be produced in large amounts by the process with energy saving and low environment loads which facilitates simple apparatuses. The conductive ZnO crystalline film produced by the present invention may be applied to a novel transparent electrode in place of the conventional ITO electrode.

Thus far, the present invention has been described using practical embodiments and the present invention must not be limited to the practical embodiments described above; for example, IV group elements such as Al and/or Ga etc. may be doped during the film forming process in order to enhance the conductivity. Other practical embodiments in the scope that a person with ordinary skill in the art may contemplate may be included in the scope of the present invention as far as such other practical embodiments should have the works and advantages of the present invention.

### EXAMPLE

Hereafter, the present preparation method for the conductive zinc oxide film will be explained using practical example; however, the present invention should not be limited by the following examples.

### (Preparation of ZnO Crystalline Film by LPD Method)

As the zinc salt aqueous solution 10mM zinc nitrate (Zn(NO₃)₂) aqueous solution was prepared. Separately to this, the ammonia aqueous solution containing citric acid by adding sodium citrate to 28% ammonia aqueous solution (NH₃) was prepared (ammonia concentration :0.89 M). In this experiment, four kinds of ammonia aqueous solutions containing citric acid which contain different concentrations of citric acid were prepared (concentration of citric acid/no addition, 0.5 mM, 2.0 mM, 10 mM).

Fig. 2 shows the spin spray apparatus 100 used in the present example. The spin spray apparatus 100 is disposed with two spray nozzles 12, 14 above the turn table equipped with the heater. The zinc nitrate aqueous solution 16 and the ammonia aqueous solution containing citric acid 18 prepared by the above described protocols were each sprayed through the spray nozzles 12, 14 separately onto the turn table 10.

After fixing the substrate 20 made of soda lime glass on the turn table 10, distilled water was sprayed from the spray nozzles 12, 14 on the turntable rotated at 120 rpm under the condition that the substrate 20 was heated to 90 Celsius degrees to rinse the surface of the substrate 20. Then, the spray nozzles 12, 14 were each connected to the zinc nitrate aqueous solution 16 and the ammonia aqueous solution containing citric acid 18 and both solutions were sprayed for 10 minutes from each nozzle under the condition that the temperature of the substrate 20 (90 Celsius degrees) and the rotation numbers (120 rpm) were kept to form the film. Then, the spray nozzles 12, 14 were connected to the distilled water again and the substrate 20 was rinsed. After the substrate 20 was cooled to an ambient temperature, the substrate 20 onto which the zinc oxide film was formed was recovered and dried by natural seasoning.

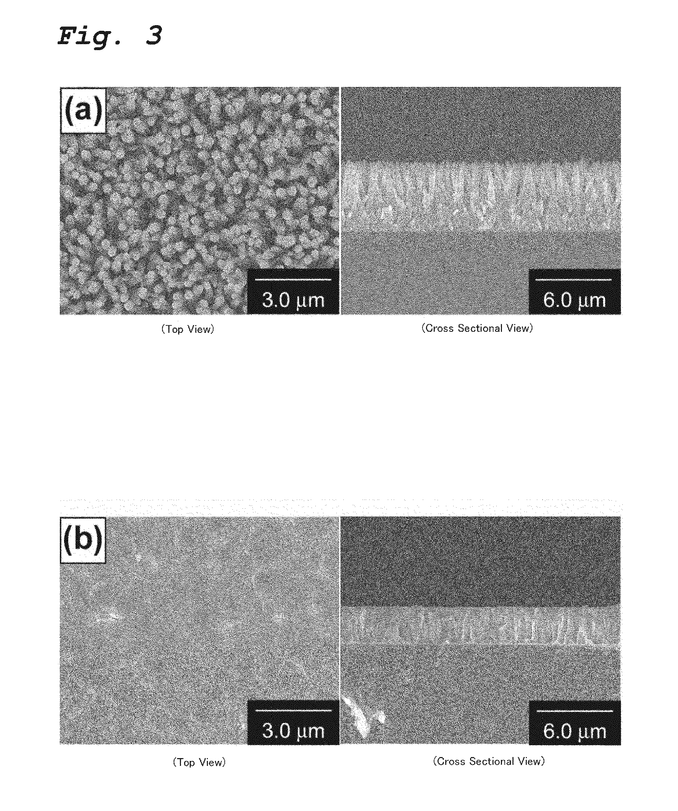

Fig. 3(a) shows the electron microscope of the zinc oxide film formed on the substrate 20 when LPD was conducted without the presence of citric acid. When the citric acid was not added, the structure that the needle like crystals with the anisotropic growth to the c axis direction randomly stood was observed.

On the other hand, Fig. 3 (b) shows the electron microscope of the zinc oxide when LPD was conducted under the presence of the citric acid (citric acid concentration : 10 mM). In the system in which LPD was conducted under the presence of the citric acid, the crystal growth to the c axis was suppressed and the continuous body with the crystal dense between the film face.

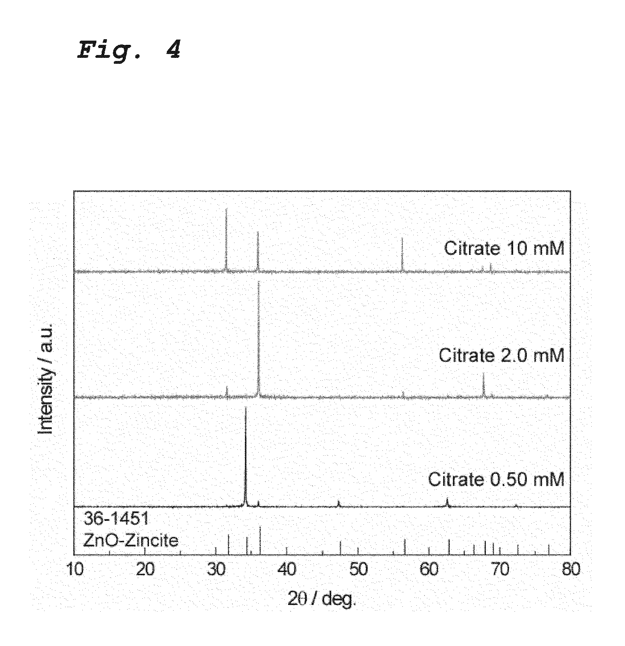

Fig. 4 shows the results of XRD measurements for each of the zinc oxide films when three kinds of ammonia aqueous solution containing the citric acid with different concentrations (0.5 mM, 2.0 mM, 10 mM). According to the results shown in Fig. 4, as the concentration of the citric acid increases, the crystal orientations change as (0002)-(1011)-(1010) by slanting the c axis of the ZnO crystal and finally, the inventors suppose that the c axis of the crystal becomes nearly parallel to the substrate.

### (Provision of Conductivity to ZnO Crystalline Film)

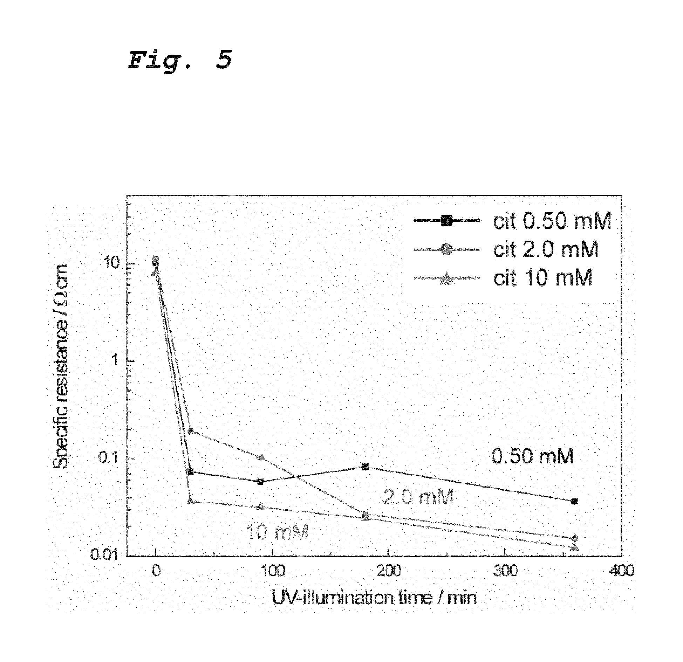

Next, the UV light with broad wavelength width of 300-400nm was irradiated to each of three kinds of zinc oxide films prepared using the ammonia aqueous solutions containing citric acid with different concentrations (0.5 mM, 2.0 mM, 10 mM). The irradiation time durations were set as a plurality of time conditions such as 0 min, 30 min, 90 min, 180 min, and 360min. Then, each of the zinc oxide films were subjected to a two terminal resistance measurement at an ambient temperature. Fig. 5 shows the relation between the UV irradiation time durations (min) and the resistivity (ohmxcm) for each of three kinds of the zinc oxide film.

As shown in Fig. 5, though the resistivity value of each zinc oxide films showed high values as high as 10 ohmxcm prior to the UV irradiation, the resistivity value of each zinc oxide films rapidly decreased and the resistivity value after 6 hour irradiation was decreased to about 1.5-3.4×10⁻² ohm cm.

Furthermore, it was confirmed that the resistivity value decreased as low as 4.4× 10⁻³ ohm cm after 20 hours irradiation. From this results, it was revealed that high conductivity might be provided to the zinc oxide film by the UV irradiation of sufficient time duration depending on the film thickness thereof. Then, it was confirmed that the lowered resistivity value was kept after terminating the UV irradiation and the provision of essential conductivities to the zinc oxide film of the present invention was confirmed.

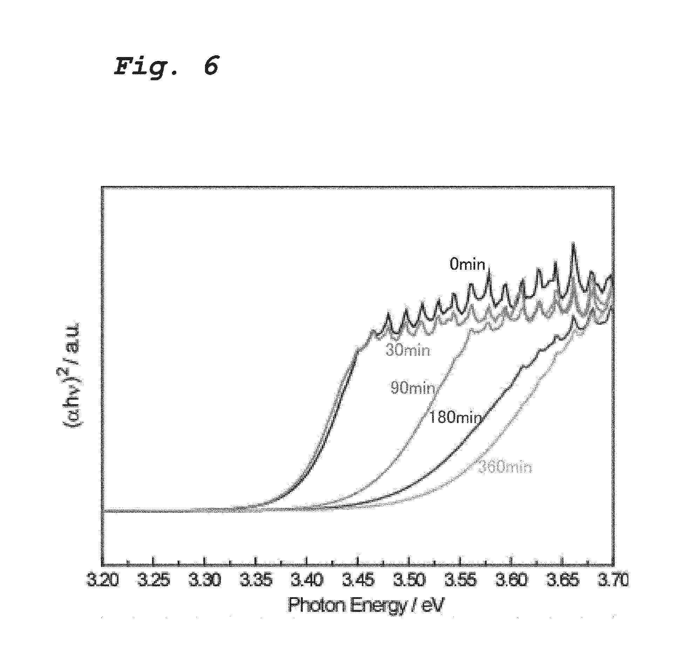

Fig. 6 illustrates the scheme for obtaining band gaps from light transmittance for the zinc oxide film prepared using the ammonia aqueous solution containing citric acid with the concentration of 10 mM. As shown in Fig. 6, the optical band gap when the UV light was not irradiated (0 min) was 3.37 eV which was almost same level of normal bulk zinc oxide; however, the optical band gap was increased gradually as the UV light was irradiated and the optical band gap increased up to 3.49 eV at the irradiation time duration (360 min). From this fact, it was shown that the absorption end of the zinc oxide shifted to shorter wavelength according to the UV light irradiation.

This result suggests that the carrier concentration in the zinc oxide film is increased as the UV light irradiation. The carrier concentration of the zinc oxide film irradiated for 6 hours with the UV light was obtained to be 1.8-3.4×10²⁰ cm⁻³ from the Hall measurement and the mobility thereof was 1-1.5×cm²/Vs. Furthermore, the carrier concentration of the zinc oxide film irradiated for 20 hours with the UV light was obtained to be 5.8×10²⁰ cm⁻³ from the Hall measurement and the mobility was 5.8×cm²/Vs. The mobility is lower than that of polycrystalline zinc oxide prepared by the conventional vapor phase method; however, the carrier concentration exhibits quite high value as the non-doped zinc oxide. It is confirmed that the decrease of resistivity according to the UV irradiation may come from the increase of the carrier concentration.

Here, in the present example, it is supposed that the carrier concentration may be increased by removal of the citric acid all over the film because of the absorption of shorter wavelength side UV light during the process of broadening of optical band gap of the zinc oxide crystal according to the UV irradiation since the black light having broad wavelength distribution from 300-400 nm.

Furthermore, the substrate 20 made of soda lime glass shown in Fig. 2 was replaced with the substrate made of plastics such as transparent PET, and the experiments were conducted in the same condition. It was confirmed that the resistivity was decreased in the magnitude of 3-4 order scale by the UV light irradiation as described above.

### Description of Signs

10-turn table
12,14-ppray nozzle
16-zinc nitride aqueous solution
18-ammonia aqueous solution containing citric acid
20-substrate
100-spin spray apparatus

## Claims

1. A method for preparing a conductive zinc oxide film, the method comprising the steps of:
precipitating a zinc oxide film on a substrate by a precipitation using liquidous solution under the presence of organic acid; and
removing the organic acid from the zinc oxide film by irradiating UV light to the substrate.

2. The method of claim 1, wherein the organic acid is carboxylic acid.

3. The method of claim 2, wherein the carboxylic acid is selected from the group consisting of citric acid, maleic acid, dimethyl-mercapto-succinic acid, phenol phtalein, and eosin-Y.

4. The method of any one of claims 1-3, wherein the precipitation step is conducted using a spin spray method.

5. The method of any one of claims 1-4, wherein the substrate is made of a material having low glass transition temperature.

6. The method of claim 5, wherein the material having the low glass transition temperature is inorganic glass.

7. The method of claim 5, wherein the material having the low glass transition temperature is a plastic material.

8. A conductive zinc oxide film being prepared by the steps of:
precipitating a zinc oxide film on a substrate by a precipitation using liquidous solution under the presence of organic acid; and
removing the organic acid from the zinc oxide film by irradiating UV light to the substrate.

9. A transparent electrode comprising the conductive zinc oxide of claim 8.
